# EUROPÄISCHE PATENTSCHRIFT

(11) **EP 0 794 847 B1**
(45) Veröffentlichungstag und Bekanntmachung des Hinweises auf die Patenterteilung: **22.07.1998**
(21) Anmeldenummer: 95940154.8
(22) Anmeldetag: 28.11.1995
(51) Int. Cl.: B23K 35/363, C23F 11/14, B23K 1/20

(54) **VERFAHREN ZUM BONDEN VON DRÄHTEN AUF OXIDATIONSEMPFINDLICHEN, LÖTBAREN METALLSUBSTRATEN**
PROCESS FOR BONDING WIRES TO OXIDATION-SENSITIVE METAL SUBSTRATES WHICH CAN BE SOLDERED
PROCEDE DE SOUDAGE DE FILS SUR DES SUBSTRATS METALLIQUES BRASABLES SENSIBLES A L'OXYDATION

(30) Priorität: 28.11.1994 DE 4444388
(43) Veröffentlichungstag der Anmeldung: 17.09.1997
(73) Patentinhaber: ATOTECH Deutschland GmbH, 10553 Berlin (DE)
(72) Erfinder: MEYER, Heinrich, D-14109 Berlin (DE); RUDOLF, Frank, D-01776 Bärenburg (DE)
(74) Vertreter: Effert, Bressel und Kollegen
(86) Internationale Anmeldenummer: DE9501755
(87) Internationale Veröffentlichungsnummer: WO9616768

(56) Entgegenhaltungen:
- EP-A- 0 428 383
- EP-A- 0 513 831
- GB-A- 2 104 107
- US-A- 3 716 421
- US-A- 5 348 590
- US-A- 5 362 334

## Beschreibung

Die Erfindung betrifft ein Verfahren zum Bonden von Drähten auf oxidationsempfindlichen, lötbaren Metallsubstraten.

Zur Herstellung elektrisch leitender Verbindungen zwischen ungehäusten Halbleiterschaltungen (Chips) und den Leiterzügen der die Schaltungen tragenden Bauelementeträger wird seit langem die Drahtbondtechnik eingesetzt. Die Verbindungen werden hierzu durch Drahtbrücken gebildet, die auf beiden Seiten mit den Anschlußplätzen auf den Oberflächen der Elektronikbauteile verschweißt werden.

Schmelzschweißverfahren können in diesem Fall nicht eingesetzt werden, da die hierfür erforderlichen hohen Temperaturen die Bauteile zerstören würden. Daher wurden Kalt- und Warm-Preßschweißverfahren als Mikrofügetechniken entwickelt. Mit den genannten Verfahren können Verbindungen mit hoher mechanischer Festigkeit und keinem elektrischen Widerstand, wie er bei der Verbindung zweier Metalle bzw. Legierungen beim Drahtbonden gefordert wird, erreicht werden. Zum Verschweißen des Drahtes mit dem Material der Anschlußoberfläche ist eine äußere Energiezufuhr notwendig, durch die eine plastische Deformation des Bonddrahtes und/oder der Metallisierungsschicht in der Verbindungszone und die Ausbildung einer möglichst großen tatsächlichen Kontaktfläche bewirkt wird.

Beim Kaltpreßschweißen wird die Energie in erster Linie durch den Preßdruck aufgebracht. Eine bevorzugte Methode, die insbesondere für thermisch empfindliche Substrate in Betracht kommt, ist die Ultraschallschweiß- bzw. -bondtechnik ("Technologie des Drahtbondens", AVT Report, Schriftenreihe für Aufbau- und Verbindungstechnik, VDI/VDE-Technologiezentrum Informationstechnik GmbH, Heft 4, August 1991, Berlin, DE). In diesem Fall wird die zur Kompression und zum Verbinden der zu bondenden Materialien erforderliche Energie in Form von elastomechanischen Schwingungen im Ultraschallfrequenzbereich unter Einwirkung von Druck (Bondkraft) zugeführt. Das Verfahren kommt ohne äußere Wärmezufuhr aus.

Nach gängiger Vorstellung werden die sich gegenüberliegenden Oberflächen beim Schweißvorgang durch die Reibung der Oberflächen aneinander zunächst gesäubert und Oxid- und andere Fremdschichten entfernt. Außerdem werden Rauhigkeitsspitzen an den Oberflächen eingeebnet. Dadurch wird ein inniger Kontakt der Oberflächen ermöglicht. In der Verbindungszone kommt es zu einer lokalen Erwärmung. Im weiteren Verlauf des Schweißvorganges werden die Kontaktflächen zunehmend plastisch deformiert, und die Bildung einer festen Verbindung beginnt. Der Vorgang verläuft weiter bis zur Bildung einer kompakten Schweißverbindung.

Die übliche Arbeitsfrequenz beim Ultraschallbonden liegt bei 60 kHz oder 100 kHz und bei einer Leistung von 0,1 Watt bis 30 Watt. Die Schwingungsamplitude beträgt im allgemeinen etwa 0,5 µm bis 2 µm, wobei die Schwingungsrichtung parallel zur Werkstückebene liegt. Es werden sehr definierte Prozeßbedingungen gefordert, um reproduzierbare Schweißkontakte zu erzeugen. Insbesondere müssen möglichst definierte Metalloberflächen vorliegen, um eine zuverlässige Kontaktierung des Drahtes zu erreichen.

Bei der Ultraschallbondtechnik werden die Kontakte durch Keile (wedges) erzeugt. Dabei wird der Draht mittels eines keilförmigen Werkzeuges an die Bondfläche herangeführt, dort unter Anpressen und Ultraschalleinwirkung verschweißt, zur zweiten Bondfläche gezogen, wobei sich ein Drahtbogen ("loop") von der ersten zur zweiten Bondfläche spannt, dort wieder unter den gleichen Bedingungen verschweißt und schließlich hinter der zweiten Schweißstelle abgetrennt.

Das Bondverfahren wurde in der Vergangenheit üblicherweise eingesetzt, um die ungehäusten Halbleiterschaltungen mit Anschlüssen auf den Bauelementeträgern zu verbinden. Das derart gebildete Ensemble aus der ungehäusten Halbleiterschaltung auf einem Bauelementeträger wurde mit einem Gehäuse versehen und dann wiederum über Anschlußstifte auf Leiterplatten gelötet.

Neuere Techniken gehen davon aus, daß die ungehäusten Halbleiterschaltungen ohne Bauelementeträger direkt auf der Leiterplattenoberfläche fixiert und durch Drahtbonden mit den Leiterbahnen elektrisch leitend verbunden werden. Daher besteht das Erfordernis, für das Drahtbonden geeignete Oberflächen auch auf den Leiterbahnen der Leiterplatten vorzusehen. Es werden üblicherweise Metallschichten aus Nickel und Gold verwendet.

Leiterzüge auf Leiterplatten bestehen in der Regel aus Kupfer, die gegebenenfalls mit Zinn- oder Zinn-Blei-Schichten überzogen sind. Die genannten Materialien sind höchstens bedingt oder überhaupt nicht geeignet, um Drähte mit diesen durch Drahtbonden zu verbinden. Auf Kupfer bilden sich leicht dicke Oxidschichten, die den Bondvorgang behindern; Zinn- und Zinn/Blei-Schichten sind nicht bondbar.

Daher wurden für den genannten Zweck bisher bevorzugt weitere Schichten aus Nickel und Gold auf die Leiterbahnen abgeschieden. Beim Bonden wird der Bonddraht vorwiegend mit der Nickelschicht verschweißt. Die die Nickelschicht überspannende, äußerst dünne Goldschicht dient lediglich dazu, die Oxidation der Nickelschicht zu verhindern, um deren Bondfähigkeit zu erhalten. Derartige Schichten sind jedoch sehr teuer. Üblicherweise werden diese Metalle erst nach der Erzeugung der Leiterbahnen abgeschieden, so daß das zusätzliche Erfordernis besteht, daß die Metalle ausschließlich auf den Kupferleiterbahnen und nicht auf den dazwischen liegenden nichtleitenden Bereichen der Leiterplatte selektiv abgeschieden werden müssen. Anderenfalls bestünde die Gefahr, daß sich leitfähige Brücken und damit Kurzschlüsse zwischen den Leiterbahnen bilden.

In einer älteren Technik werden die Nickel- und Goldschichten unmittelbar nach der ganzflächigen Metallisierung der Leiterplattenoberflächen und Bohrlöcher auf den Kupferoberflächen abgeschieden. Dies hat jedoch den Nachteil, daß zum einen erhebliche Mengen des teuren Goldes aufgebracht werden müssen und zum zweiten, daß die nachträgliche Entfernung dieser Schichten zur Erzeugung der Leiterbahnen durch Ätzprozesse schwierig ist.

Aus US-A 53 48 590 ist ein Oberflächenbehandlungsmittel für Kupfer und Kupferlegierungen, insbesondere auf Leiterplatten, zur Vorbehandlung vor dem Löten bekannt, das als Löthilfsmittel ein disubstituiertes 2-Alkylbenzimidazol sowie als Chelatisierungsagens für Kupfer eine Aminocarbonsäure enthält.

Ferner ist auch aus EP 0 428 383 A1 ein Verfahren zur Lötvorbehandlung von Kupfer oder einer Kupferlegierung bekannt, wobei die zu behandelnden Flächen mit einer Lösung eines ein- oder mehrfach mit Alkylgruppen substituierten 2-Alkylbenzimidazols und einer organischen Säure in Kontakt gebracht werden. Als 2-Alkylbenzimidazol werden beispielsweise 2-Pentyl-, 2-Hexylbenzimidazol und 2-Propyl-5-methylbenzimidazol und als organische Säure beispielsweise Essigsäure eingesetzt.

In diesen beiden Druckschriften werden jedoch keine Hinweise auf die Lösung des zuvor beschriebenen Problems gegeben, Bonddrähte von Halbleiterbauelementen durch Ultraschallschweißen mit den Leiterplattenoberflächen direkt zu verbinden.

Aus der Patentschrift DD 136 324 ist ein Verfahren zum Bonden auf stärker oxidierenden Anschlußflächen bekannt, bei der auf die Anschlußflächen nach ihrer Reinigung und Vorbereitung eine dünne Schutzschicht aufgetragen wird, die beim Bonden zerreißt. Es wird insbesondere beschrieben, daß Kupferoberflächen mit Chromatierlösungen, bestehend aus Chromtrioxid und Schwefelsäure in Wasser, behandelt werden. Dabei entsteht eine sehr dünne, gegebenenfalls nur wenige Atomlagen dicke Schutzschicht auf der Kupferoberfläche.

Für eine breite Anwendung der genannten Technik ist es jedoch erforderlich, daß die für das Bonden vorbereiteten Oberflächen insbesondere ohne Anwendung aggressiver Flußmittel auch lötbar sind. In der Regel sollen auf den Leiterplattenoberflächen nicht nur Halbleiterschaltungen direkt montiert und gebondet werden. Auf die Oberflächen werden gleichzeitig auch andere Bauelemente, wie beispielsweise Widerstände, Kondensatoren und gehäuste Halbleiterschaltungen montiert und durch Löten elektrisch verbunden. Die nach der DD 136 324 gebildeten Schichten sind jedoch, zumindest ohne Anwendung aggressiver Lothilfsmittel, nicht lötbar. Daher eignen sich derartige Schichten zum Schutz des Kupfers gegen Oxidation nicht als Schutzschichten für eine nachfolgende Bauelementebestückung durch Löten. Im übrigen verändern sich diese Schichten bei längerer Lagerungszeit bei erhöhter Temperatur, so daß keine reproduzierbaren Ergebnisse beim Bonden und beim Löten möglich sind.

Derartige Verfahren sind insbesondere wegen der hohen Konzentration von Chromtrioxid in der Chromatierlösung überdies außerordentlich giftig, so daß aufwendige Maßnahmen zum Arbeitsschutz und bei der Abwasseraufbereitung getroffen werden müssen.

Der vorliegenden Erfindung liegt von daher das Problem zugrunde, die Nachteile des Standes der Technik zu vermeiden und ein Verfahren zum Bonden von Drähten auf oxidationsempfindlichen Metallsubstraten mittels Ultraschallschweißen zu finden, das gleichermaßen ein nachfolgendes Löten erlaubt. Insbesondere besteht die Aufgabe auch darin, ein Verfahren zur Herstellung von mit auf Kupferstrukturen gelöteten Bauelementen und mit direkt elektrisch leitend kontaktierten ungehäusten Halbleiterschaltungen bestückten Leiterplatten zu finden.

Die Aufgabe wird gelöst durch die Ansprüche 1 und 3. Bevorzugte Ausführungsformen der Erfindung sind in den Unteransprüchen angegeben.

Die Erfindung besteht darin, daß die zu bondenden Drähte durch ein Preßschweißverfahren mit Ultraschall mit dem Metallsubstrat verbunden werden, nachdem das Metallsubstrat zum Schutz gegen Oxidation und andere Verunreinigungen vor dem Bondvorgang mit organischen Schutzschichten durch In-Kontakt-Bringen der Metallsubstrate mit einer Stickstoffverbindungen enthaltenden Lösung versehen wird. Zur reproduzierbaren Applikation einer derartigen Schutzschicht wird die Fläche, die Kontakt mit den Bonddrähten erhält, von Oxiden und sonstigen die Bondverbindung eventuell beeinträchtigenden Belägen oder auch organischen Verschmutzungen befreit.

Das Verfahren kommt insbesondere für Metallsubstrate aus Kupfer oder Kupferlegierungen in Betracht. Es beruht auf der Erkenntnis, daß frische, nicht mit Oxiden oder Adsorbaten kontaminierte Kupferflächen gut bondbar sind. Wegen der hohen Reaktivität von Kupfer ist es indes nicht möglich, die nötige Reinheit der Oberflächen auch unter technischen Bedingungen zu gewährleisten. Der Erfindungsgedanke besteht darin, die Kupferoberfläche durch eine geeignete dünne organische Schutzschicht vor dem Angriff des Luftsauerstoffes und anderer korrosiver Adsorbate zu schützen. Die dünne organische Schicht muß jedoch noch einer weiteren Voraussetzung genügen: Die geschweißte Verbindung zwischen dem Draht und dem Metallsubstrat darf durch die Anwesenheit der organischen Schutzschicht nicht beeinträchtigt werden. Der direkte metallische Kontakt zwischen dem Bonddraht und der Metallsubstratoberfläche muß beim Bonden unbedingt hergestellt werden. Oxide und andere Oberflächenverbindungen, wie beispielsweise Adsorbate, verhindern diesen Kontakt. Es hat sich herausgestellt, daß die organische Schutzschicht beim Bondvorgang in geeigneter Weise durchbrochen oder entfernt wird.

Die mehr als 50 nm, vorzugsweise 100 bis 500 nm, dicke organische Schutzschicht führt überraschenderweise nicht dazu, daß die Haftfestigkeit des Kontaktes zwischen dem Bonddraht und dem Metallsubstrat beeinträchtigt wird. Derartige organische Schutzschichten werden zwar beim Löten von Metallsubstraten eingesetzt. In diesem Fall ist die Lötverbindung jedoch gegenüber organischen Verunreinigungen der zu verbindenden Substrate unempfindlich, da der Lötkontakt nicht nur an den Oberflächen der Substrate gebildet wird. Beim Löten bilden sich meist intermetallische Phasen (Diffusion) zwischen den Substraten aus, so daß Verunreinigungen praktisch keinen nachteiligen Einfluß auf die Haftfestigleit des Verbundes haben, sofern diese nicht schon durch Temperatureinwirkung von der Lötkontaktfläche entfernt wurden. Im Gegensatz dazu wird der Kontakt zwischen dem Bonddraht und dem Metallsubstrat nur an der in atomaren Dimensionen liegenden Kontaktfläche gebildet (Adhäsion), so daß Verunreinigungen, insbesondere organischer Art, einen starken negativen Einfluß auf die Haftfestigkeit des Verbundes ausüben können. Daß anorganische metallische Minimal-Schichten keinen negativen Einfluß haben, ist noch erklärlich für stoffschlüssig verbindbare Metalle, jedoch nicht, daß auch die erfindungsgemäßen organischen Verbindungen keinen negativen Einfluß haben.

Das Verfahren weist verschiedene daher unerwartete Vorteile gegenüber dem Stand der Technik auf: Es können Drähte auf oxidationsempfindliche Oberflächen, beispielsweise aus Kupfer oder Kupferlegierungen, gebondet werden, ohne daß diese unmittelbar vor dem Bondverfahren gereinigt werden müssen. In der Regel ist damit zu rechnen, daß die Metalloberflächen vor dem Bondprozeß über eine längere Zeit hinweg gelagert werden und dabei unter Umständen auch korrosiven Gasen ausgesetzt sind. Diese Wartezeiten können unterschiedlich lang sein. Außerdem besteht mitunter die Notwendigkeit, die Substrate vor dem Drahtbonden einer Wärmebehandlung zu unterziehen, so daß sich dickere Oxidationsschichten auf den Metalloberflächen bilden. Derartige Kontaminationen behindern den Bondvorgang oder verhindern die Bildung der Schweißverbindung vollständig.

Durch die organische Schutzschicht wird die Bildung derartiger Oxide und anderer Kontaminationen zumindest stark behindert. Wartezeiten und Wärmebeanspruchungen des Substrates vor dem Bonden wirken sich nicht in nennenswertem Umfange auf das Bondergebnis aus.

Die Schichten sind ferner auch lötbar. Daher können auf demselben Substrat beispielsweise ungehäuste Halbleiterschaltungen durch Bonden und andere Bauelemente, wie beispielsweise Widerstände, Kondensatoren und gehäuste Halbleiterschaltungen durch Löten elektrisch leitend kontaktiert werden.

Das Verfahren ist darüberhinaus umweltfreundlich, da keine gefährdenden Substanzen, wie beispielsweise Chromate, verwendet werden. Es ist auch kostengünstig und sicher, da auf die aufwendigen stromlosen Metallisierungsverfahren zur Abscheidung von Nickel und Gold verzichtet werden kann.

Die organischen Schutzschichten werden durch In-Kontakt-Bringen der Metallsubstrate mit einer Stickstoffverbindungen enthaltenen Lösung gebildet. Als Stickstoffverbindungen werden insbesondere Alkyl-, Aryl- oder Aralkylimidazole oder -benzimidazole mit Alkylresten mit mindestens drei Kohlenstoffatomen verwendet. Es handelt sich in diesem Fall vorzugsweise um die in 2-Stellung substituierten Derivate. Grundsätzlich können die in den Druckschriften EP 0428383 A1, EP 0428260 A2, EP 0364132 A1, EP 0178864 B1, EP 0551112 A1, CA 2026684 AA, WO 8300704 A1, JP 3235395 A2, JP 4080375 A2, JP 4159794 A2, JP 4162693 A2, JP 4165083 A2, JP 4183874 A2, JP 4202780 A2, JP 5025407 A2, JP 5093280 A2, JP 5093281 A2, JP 5098474 A2, JP 5163585 A2, JP 5202492 A2 und JP 6002158 A2 beschriebenen Stickstoffverbindungen sowie die weiteren dort angegebenen Zusatzstoffe verwendet werden.

Die Lösung, aus der die organischen Schutzschichten abgeschieden werden, hat vorzugsweise einen pH-Wert unter 7 und insbesondere zwischen 2 und 5. Die Lösung wird durch Zugabe von Säuren auf den gewünschten pH-Wert eingestellt. Hierzu eignen sich sowohl anorganische als auch organische Säuren, wie beispielsweise Phosphorsäure, Schwefelsäure, Salzsäure und Ameisensäure.

Das erfindungsgemäße Verfahren dient insbesondere zur Herstellung von mit auf Kupferstrukturen gelöteten gehäusten Bauelementen und mit direkt elektrisch leitend kontaktierten ungehäusten Halbleiterschaltungen bestückten Leiterplatten.

Hierzu sind die folgenden wesentlichen Verfahrenschritte erforderlich:
- Herstellen der Kupferstrukturen auf den Leiterplattenoberflächen,
- Bilden organischer Schutzschichten auf den Kupferstrukturen,
- mechanisches Fixieren und Löten der gehäusten Bauelemente auf den Leiterplattenoberflächen,
- Befestigen der ungehäusten Halbleiterschaltungen auf den Leiterplattenoberflächen,
- elektrisches Kontaktieren von auf den ungehäusten Halbleiterschaltungen vorgesehenen Bondinseln mit den Kupferstrukturen durch Preßschweißen von Drähten mit Ultraschall.

Das Verfahren kann auch bei der Herstellung anderer Verbindungsträger, wie beispielsweise von Multi-Chip-Modulen oder Chipträgern angewendet werden.

Die Verfahrensschritte werden in der angegebenen Reihenfolge oder auch in einer anderen Reihenfolge durchlaufen. Zusätzlich zu den angegebenen werden gegebenenfalls weitere Verfahrensschritte ausgeführt, die im folgenden dargestellt werden.

Als Grundmaterialien für die die Kupferstrukturen tragenden Substrate werden neben FR4- bzw. FR5- (flammhemmendes Epoxidharz/Glasfaser-Laminat), Polyimid und anderen Materialien auch Keramiken eingesetzt. Auf diesen im allgemeinen plattenförmigen Trägern werden Kupferstrukturen durch bekannte Techniken erzeugt (Handbuch der Leiterplattentechnik, Band II, Hrsg. G. Herrmann, Eugen G. Leuze Verlag, Saulgau, 1991). Gegebenenfalls enthalten die Träger auch Bohrlöcher, die zur Verbindung einzelner Leiterzugebenen dienen und hierzu mit Kupferschichten metallisiert sind.

Nach dem Erzeugen der Kupferstrukturen auf den Substrataußenseiten wird üblicherweise eine Lötstopmaske auf jede Seite des Trägers aufgebracht, um die Bereiche der Kupferstrukturen abzudecken, zu denen keine weiteren elektrisch leitenden Verbindungen mit gehäusten Bauelementen oder ungehäusten Halbleiterschaltelementen vorgesehen sind. Anschließend kann die organische Schutzschicht auf den freiliegenden Kupferoberflächen gebildet werden. Hierzu werden diese zunächst gereinigt und anschließend oberflächlich angeätzt. Zur Reinigung werden saure und alkalische Lösungen verwendet, um Oxidschichten und andere Verunreinigungen, wie beispielsweise Fette und Öle, zu entfernen. Die Lösungen enthalten daher neben Säuren oder Basen gegebenenfalls auch Netzmittel. Nach der Reinigung werden die Oberflächen angeätzt, um ein rauhes Oberflächenprofil zu erzeugen. Nachfolgend aufgebrachte Schichten haften dadurch besser auf der Oberfläche. Es werden die in der Leiterplattentechnik gebräuchlichen Ätzlösungen für Kupfer verwendet. Zwischen den Behandlungsstufen werden die Oberflächen gründlich gespült, um anhaftende Lösungen zu entfernen.

Vor der nachfolgenden Bildung der organischen Schutzschichten werden die Oberflächen in der Regel noch einmal in eine schwefelsaure Lösung getaucht und ohne weitere Behandlung unmittelbar danach mit der die Stickstoffverbindungen enthaltenen Lösung in Kontakt gebracht. Durch den Kontakt bildet sich auf der Kupferoberfläche ein Überzug aus den Stickstoffverbindungen. Die Temperatur der Behandlungslösung wird vorzugsweise zwischen 30 ^{°} C und 50 °C gewählt. Je nach gewünschter Schichtdicke sind Behandlungszeiten zwischen 0,5 und 10 Minuten geeignet. Es können Schichtdicken zwischen etwa 0,1 µm und 0,5 µm reproduzierbar erzeugt werden. Dünnere Schichten verhindern die Oxidation der geschützten Metalloberflächen nicht ausreichend. Dickere Schichten behindern die Bondfähigkeit der Oberflächen.

Die Schutzschicht kann durch Tauchen, Sprühen, Schwallen in vertikaler oder in horizontaler Anordnung der Substrate gebildet werden. Die übliche Verfahrensweise besteht im Eintauchen der vertikal gehaltenen Substrate in ein Tauchbad. In neuerer Zeit hat sich die Horizontaltechnik durchgesetzt, bei der die Substrate in horizontaler Lage und Richtung durch eine Behandlungsanlage geführt und von einer oder beiden Seiten über Düsen mit den Behandlungslösungen beschwallt werden. Die Wirksamkeit der Behandlung in Tauchbädern wird durch Bewegung der Substrate und zusätzliche Einwirkung von Ultraschall intensiviert.

Nach der Bildung der Schutzschicht wird diese getrocknet und gegebenenfalls getempert.

Falls Bauelemente wie Widerstände, Kondensatoren und gehäuste Halbleiterschaltungen durch Löten mit den Kupferstrukturen elektrisch leitend verbunden werden sollen, können anschließend Lotdepots an den geeigneten Stellen auch durch Drucken von Lotpasten aufgebracht werden. Danach werden die Bauelemente selbst durch Aufkleben auf die Leiterplattenoberfläche mechanisch fixiert. Durch ein Umschmelzlötverfahren werden die Anschlußkontakte der Bauelemente mit den Kupferstrukturen leitend verbunden. Als Umschmelzverfahren kommen beispielsweise das Infrarot-, Dampfphasen- und das Laserlötverfahren in Betracht. Die genannten Verfahrensschritte sind beispielsweise im Handbuch der Leiterplattentechnik, Band III, Hrsg. G. Herrmann, Eugen G. Leuze Verlag, Saulgau, 1993, näher beschrieben.

Danach werden die direkt mit dem Substrat zu verbindenden ungehäusten Halbleiterschaltungen auf die Kupferstrukturen geklebt.

Zur elektrisch leitenden Kontaktierung der Anschlußplätze auf den Halbleiterschaltungen mit den Kupferstrukturen wird insbesondere das zu den Mikrofügetechniken rechnende Ultraschallbondverfahren eingesetzt. Dieses kommt ohne zusätzliche äußere Wärmezufuhr beim Bondprozeß aus. Zum Bonden wird vorzugsweise Aluminiumdraht verwendet. Es sind jedoch auch Kupfer-, Gold- und Palladiumdrähte möglich. Aluminiumdraht wird besonders mit Drahtdurchmessern zwischen 17,5 µm und 500 µm eingesetzt. Dickere Drähte mit einem Durchmesser oberhalb von 100 µm werden aus Reinstaluminium hergestellt. Dünnere Drahtquerschnitte können aus Festigkeitsgründen nicht aus reinem Aluminium gezogen und verarbeitet werden. Zur Härtung werden diese mit 1 % Silizium oder 0,5 % bis 1 % Magnesium legiert. Mit dünneren Drähten können Verbindungen auf kleineren Kontaktierungsplätzen auf den ungehäusten Halbleiterschaltungen und auf den Kupferstrukturen gebildet werden. Dickere Drähte werden bei Baugruppen der Leistungselektronik eingesetzt.

Charakteristische Verfahrensparameter beim Ultraschalldrahtbonden sind die Ultraschalleistung, die Bondkraft und die Bondzeit. Neben der Voraussetzung, eine sichere, d.h. feste Verbindung zwischen dem Draht und den Bondflächen zu erzeugen, besteht die weitere Notwendigkeit, eine größtmögliche Produktivität, d.h. eine möglichst geringe Zykluszeit (Herstellungszeit einer Drahtbrücke) zu erreichen. Hierzu werden die genannten Parameter optimiert.

Die Ultraschalleistung wird abhängig vom Drahtdurchmesser gewählt. Die maximale Leistung der Ultraschallgeneratoren liegt zwischen 5 Watt und 30 Watt. Die Anpreßkraft des Werkzeuges beim Bonden des Drahtes auf die Anschlußfläche beträgt in der Regel zwischen 250 mN und 1000 cN. Die Bondzeit liegt vorzugsweise zwischen 30 msec und 500 msec. Die unteren Bereiche der genannten Parameter betreffen jeweils, wiederum in Abhängigkeit vom Drahtdurchmesser, das Dünndraht-, die oberen das Dickdrahtbonden.

Für die wedge-wedge-Technik, die beim Ultraschallbonden mit Aluminiumdrähten bevorzugt eingesetzt wird, werden Werkzeuge in Form eines Stempels mit keilförmiger Spitze (Bondkeil) verwendet. Das Werkzeug besteht üblicherweise aus Wolframcarbid, einem gesinterten Hartmetall mit Kobalt als Bindemittel. Weiterhin sind Stahl oder Titancarbid möglich. Meist ist die Drahtführung zusätzlich im Werkzeug integriert.

Zum Bonden werden manuelle und automatisch gesteuerte Anlagen verwendet. Die Anlage besteht im wesentlichen aus dem Bondkopf, der das Werkzeug hält, der Ultraschalleinheit, dem Werkstückhalter, einer Steuerelektronik und optischen Hilfsmitteln zur Positionierung der Verbindungspartner.

Die Qualität der Bondverbindung kann mit unterschiedlichen Verfahren getestet werden. Um die Haftfestigkeit der Bondverbindung zu ermitteln, wird bevorzugt der Zugtest eingesetzt. Hierzu wird ein kleiner Haken in der Mitte zwischen den beiden Bondkontakten unter der Drahtschlaufe plaziert und mit konstanter Geschwindigkeit nach oben gezogen bis die Drahtschlaufe zerreißt. Die Zugkraft wird mit Hilfe einer Meßvorrichtung gemessen und die Kraft, die zum Zerreißen der Drahtschlaufe führt, registriert. Es ist jedoch zu beachten, daß unter Umständen nicht die Fügestelle in sich zerreißt, sondern infolge deren hoher Festigkeit nahe neben ihr der Draht. Dies ist insbesondere dann der Fall, wenn die Bondverbindung durch hohe Bondenergie stark deformiert und der Bonddraht daher in der Nähe der Verbindung eingekerbt wird.

Die nachfolgenden Ausführungsbeispiele dienen zur Erläuterung der Erfindung:

### Beispiel 1 und Vergleichsbeispiel:

FR4-Leiterplatten (Basismaterial der Firma Isola, Düren, DE) mit einer Kupferstruktur, die das Bonden von etwa 2,5 mm langen Drahtbrücken erlaubt, wurden nach dem Strukturieren mit nachfolgendem Verfahren behandelt:

| | Verfahrensschritte | Behandlungszeit [Minuten] | Temp. [°C] |
|---|---|---|---|
| 1. | Reinigen der Kupferoberfläche in einer schwefelsauren, wäßrigen Caroat-Ätzlösung | 2 bis 3 | 40 bis 50 |
| 2. | Spülen in Wasser | | |
| 3. | Reinigen in alkalischer netzmittelhaltiger wäßriger Lösung | 2 bis 3 | 40 bis 50 |
| 4. | Spülen in Wasser | | |
| 5. | Ätzreinigen in einer schwefelsauren, wäßrigen Wasserstoffperoxidlösung | 2 bis 3 | 30 bis 40 |
| 6. | Spülen in Wasser | | |
| 7. | 5 Vol.-% wäßrige Schwefelsäure-Lösung | 1 | Raumtemp. |
| 8. | Spülen in Wasser | | |
| 9. | Bilden der org. Schutzschicht | 1 | 30 bis 50 |
| 10. | Spülen in Wasser | | |
| 11. | Trocknen | 5 bis 10 | 60 bis 80 |

Zum Bilden der organischen Schutzschicht wurde eine Lösung, enthaltend 10 g/l 2-n-Heptylbenzimidazol und 32 g/l Ameisensäure in Wasser, verwendet.

Ein Teil der Leiterplatten wurde anschließend bei Raumtemperatur ohne weitere Vorkehrungen gelagert. Ein weiterer Teil wurde zur Simulation der Aushärtebedingungen beim Kleben der Halbleiterschaltkreise 2 h lang bei 80 °C und ein dritter Teil 1 h lang bei 150 °C getempert.

Anschließend wurde ein AlSi1-Bonddraht (Aluminium mit 1 % Silizium) mit einem Durchmesser von 30 µm auf die Kupferstrukturen gebondet (Hersteller Heraeus, Hanau, DE). Der Draht wies eine Festigkeit von 19 bis 21 cN Zerreißkraft bei einer 2 bis 5 %igen Dehnung auf.

Die einzelnen Bondverbindungen wurden mit einem manuellen Drahtbonder vom Typ MDB 11 (Hersteller Elektromat, Dresden, DE) durchgeführt. Es wurde ein Standardbondkeil vom Typ DS 3102.02-18 L (Elektromat, Dresden, DE) eingesetzt.

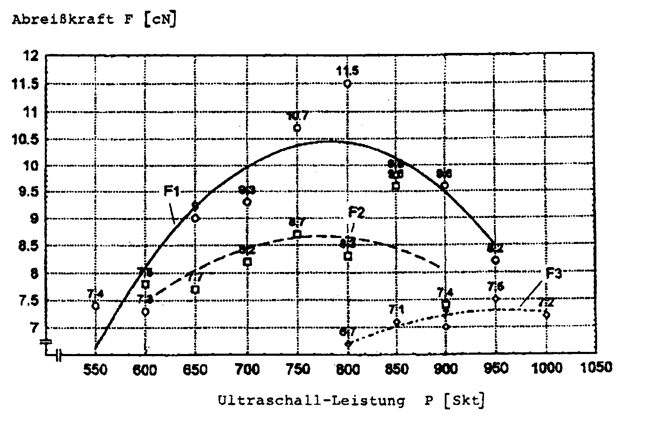

Bei konstanter Bondkraft von etwa 40 cN und einer Bondzeit von etwa 200 msec wurde die Ultraschalleistung in einem Bereich von 550 bis 1000 Skalenteilen, entsprechend etwa 0,5 Watt bis 1 Watt, variiert. In der Abbildung sind Ergebnisse der einzelnen Untersuchungen als graphische Darstellung der Abhängigkeiten der mit dem Zugtest ermittelten Abreißkraft von der Ultraschalleistung bei konstanter Bondkraft und -zeit wiedergegeben. Kurve F1 gibt die mittlere Abreißkraft bei Bondverbindungen ohne weitere thermische Lagerung des Substrates vor dem Drahtbonden an, Kurve F2 die mittlere Abreißkraft nach einer zwei Stunden langen thermischen Lagerung des Substrates vor dem Drahtbonden bei 80 ^{°} C und Kurve F3 die mittlere Abreißkraft nach einer eine Stunde langen thermischen Behandlung des Substrates vor dem Drahtbonden bei 150 ^{°} C.

Die Ergebnisse belegen, daß die mit den organischen Schutzschichten versehenen Kupferstrukturen auf den Leiterplatten bondbar sind und die Drahtbrücken eine akzeptable Festigkeit aufweisen. Jeder in der Abbildung angegebene Meßpunkt liegt deutlich oberhalb der in der internationalen Standardvorschrift MIL-STD-883C, Methode 2011 geforderten Mindestabreißkraft an Drahtbrücken von 3 cN. Es traten keine Ausfälle beim Bonden auf.

Im Gegensatz dazu konnten nicht mit der organischen Schutzschicht versehene Leiterplatten ohne unmittelbar vorangegangene Reinigung der Kupferoberflächen nicht bzw. nicht zuverlässig gebondet werden, da die Festigkeit der Bondverbindungen vor allem bei den Substraten mit thermischer Beanspruchung vor dem Drahtbonden nicht ausreichend war. Außerdem war die Ausbeute gering.

### Beispiele 2 bis 8:

Unter den Bedingungen von Beispiel 1 wurde mit den folgenden Lösungen zur Bildung der organischen Schutzschichten gearbeitet:
- 2.: 10 g/l 2-n-Heptylbenzimidazol
33 g/l Ameisensäure
1,0 g/l Kupfer(II)chlorid (CuCl₂. 2 H₂O)
in Wasser
- 3.: 5 g/l 2-n-Heptylbenzimidazol
1 g/l 1H-Benzotriazol
1 g/l Zinkacetat Dihydrat
33 g/l Eisessig
in Wasser
- 4.: 5 g/l 2,4-Diisopropylimidazol
32 g/l Eisessig
in Wasser
- 5.: 5 g/l 2,4-Dimethylimidazol
5 g/l 2-n-Nonylbenzimidazol
1 g/l Toluol-4-sulfonsäure Monohydrat
35 g/l Ameisensäure
in Wasser
- 6.: 2-(1-Ethylpentyl-benzimidazol)
32 g/l Eisessig
in Wasser
- 7.: 10 g/l 2-Phenylbenzimidazol
2 g/l Ethylamin
60 ml/l Salzsäure, 37 Gew.-%ig
in Wasser
- 8.: 10 g/l 2-Phenylbenzimidazol
35 g/l Eisessig
in Wasser
- 9.: 10 g/l 2-Ethylphenylbenzimidazol
1 g/l Zinkacetat Dihydrat
33 g/l Ameisensäure
in Wasser

Es wurden einwandfreie Bondergebnisse auch nach einer Lagerung der mit Bonddraht zu bestückenden Metalloberflächen bei erhöhter Temperatur erhalten.

## Patentansprüche

1. Verfahren zum Bonden von Drähten mittels Ultraschallschweißen auf einer gleichermaßen zum Löten geeigneten Oberfläche eines oxidationsempfindlichen Metallsubstrats, wobei vor dem Bonden mindestens an durch Bonddrähte zu kontaktierenden Bereichen die Oberfläche von Oxiden und/oder sonstigem organischem oder anorganischem Belag befreit, anschließend auf diese Oberfläche durch Kontaktieren mit einer Stickstoffverbindungen enthaltenden Lösung eine organische Schutzschicht von 100 bis 500 nm Dicke aufgebracht wird und anschließend die Drähte auf das Metallsubstrat gebondet werden.

2. Verfahren nach Anspruch 1, dadurch gekennzeichnet, daß Metallsubstrate aus Kupfer oder Kupferlegierungen verwendet werden.

3. Verfahren zur Herstellung von mit auf Kupferstrukturen gelöteten gehäusten Bauelementen und mit direkt elektrisch leitend kontaktierten ungehäusten Halbleiterschaltungen bestückten Leiterplatten mit folgenden wesentlichen Verfahrensschritten:
- Herstellen der Kupferstrukturen auf den Leiterplattenoberflächen,
- Entfernen von Oxiden und/oder sonstigem organischem oder anorganischem Belag von den Oberflächen und anschließendes Kontaktieren der Oberfläche mit einer Stickstoffverbindungen enthaltenden Lösung, bis eine organische Schutzschicht von 100 - 500 nm Dicke aufgebracht ist,
- mechanisches Fixieren und Löten der gehäusten Bauelemente auf den Leiterplattenoberflächen,
- Befestigen der ungehäusten Halbleiterschaltungen auf den Leiterplattenoberflächen,
- elektrisches Kontaktieren von auf den ungehäusten Halbleiterschaltungen vorgesehenen Bondinseln mit den Kupferstrukturen durch Preßschweißen von Drähten mit Ultraschall.

4. Verfahren nach einem der vorstehenden Ansprüche, dadurch gekennzeichnet, daß als Stickstoffverbindungen Alkyl-, Aryl- oder Aralkylimidazole oder -benzimidazole mit Alkylresten mit mindestens drei Kohlenstoffatomen verwendet werden.

5. Verfahren nach einem der vorstehenden Ansprüche, dadurch gekennzeichnet, daß die die Stickstoffverbindungen enthaltende Lösung einen pH-Wert unter 7, vorzugsweise zwischen 2 und 5, hat.

## Claims

1. Method of bonding wires by means of ultrasonic welding on a surface of an oxidation-sensitive metal substrate, which surface is equally suitable for soldering, the surface being freed of oxides and/or other organic or inorganic covering, prior to the bonding process, at least at regions which are to be contacted by bonding wires, an organic protective layer with a thickness of from 100 nm to 500 nm being subsequently applied to this surface by contacting with a solution containing nitrogen compounds, and the wires being subsequently bonded onto the metal substrate.

2. Method according to claim 1, characterised in that metal substrates formed from copper or copper alloys are used.

3. Method of producing housed components, which are soldered on copper structures, and circuit boards, which are provided with unhoused semiconductor circuits which are contacted directly in an electrically conductive manner, having the following essential method steps:
- producing copper structures on the circuit board surfaces,
- removing oxides and/or other organic or inorganic covering from the surfaces and subsequently contacting the surface with a solution containing nitrogen compounds until an organic protective layer with a thickness of between 100 nm and 500 nm is applied,
- mechanically fixing and soldering the housed components an the circuit board surfaces,
- securing the unhoused semiconductor circuits on the circuit board surfaces, and
- electrically contacting bonding pads, which are provided on the unhoused semiconductor circuits, with the copper structures by pressure-welding wires with ultrasonics.

4. Method according to one of the preceding claims, characterised in that alkyl, aryl or aralkyl imidazoles or alkyl, aryl or aralkyl benzoimidazoles with alkyl residues having at least three carbon atoms are used as the nitrogen compounds.

5. Method according to one of the preceding claims, characterised in that the solution containing the nitrogen compounds has a pH value of less than 7, preferably between 2 and 5.

## Revendications

1. Procédé de soudage de fils au moyen de la soudure par ultrasons sur une surface, appropriée de la même manière pour le brasage, d'un substrat métallique sensible à l'oxydation, la surface étant débarrassée, d'oxydes et/ou d'un autre revêtement organique ou inorganique avant le bonding au moins sur-des zones à contacter par des fils de bonding, une couche de protection organique d'une épaisseur de 100 à 500 nm étant appliquée ensuite sur cette surface par bonding avec une solution contenant des composés azotés et les fils étant ensuite appliqués par bonding sur le substrat métallique.

2. Procédé selon la revendication 1, caractérisé en ce qu'on utilise des substrats métalliques à base de cuivre ou d'alliages de cuivre.

3. Procédé pour la fabrication de composants enfermés soudés sur des structures de cuivre et de cartes imprimées équipées de circuits à semi-conducteurs non enfermés et directement contactés par électroconduction, comprenant les étapes de procédé suivants :
- préparation des structures de cuivre sur les surfaces de cartes imprimées,
- enlèvement d'oxydes et/ou d'un autre revêtement organique ou inorganique des surfaces suivi d'un établissement de contact de la surface avec une solution contenant des composés azotés, jusqu'à ce qu'une couche organique de protection de 100 à 500 nm d'épaisseur soit appliquée,
- fixation mécanique et brasage des composants enfermés sur les surfaces des cartes imprimées,
- fixation des circuits à semi-conducteurs non enfermés sur les surfaces de cartes imprimées,
- établissement de contact électrique d'îlots de bonding prévus sur les circuits à semi-conducteurs non enfermés avec les structures de cuivre par soudage avec pression de fils par ultrasons.

4. Procédé selon l'une quelconque des revendications précédentes, caractérisé en ce qu'on utilise comme composés azotés des alkylimidazoles, des arylimidazoles ou des aralkylimidazoles ou des alkylbenzimidazoles, des arylbenzimidazoles ou des aralkylbenzimidazoles avec des restes alkyle présentant au moins trois atomes de carbone.

5. Procédé selon l'une quelconque des revendications précédentes, caractérisé en ce que la solution contenant les composés azotés a un pH inférieur à 7, de préférence entre 2 et 5.
